**Europäisches Patentamt**

**European Patent Office**

**Office européen des brevets**

(19)

(11) Veröffentlichungsnummer : **0 050 202
B1**

(12) **EUROPÄISCHE PATENTSCHRIFT**

(45) Veröffentlichungstag der Patentschrift :
**13.06.84**

(21) Anmeldenummer : **81106475.7**

(22) Anmeldetag : **20.08.81**

(51) Int. Cl.³ : **H 03 J 1/06,** H 04 N 5/64,
H 04 B 1/08

(54) **Drucktastenaggregat.**

(30) Priorität : **18.10.80 DE 3039402**

(43) Veröffentlichungstag der Anmeldung :
**28.04.82 Patentblatt 82/17**

(45) Bekanntmachung des Hinweises auf die Patenterteilung : **13.06.84 Patentblatt 84/24**

(84) Benannte Vertragsstaaten :
**FR GB IT**

(56) Entgegenhaltungen :
**DE-A- 1 591 713**
**DE-A- 1 911 898**
**DE-A- 2 833 184**
**FR-A- 2 300 370**
**GB-A- 1 389 520**
**FUNKSCHAU, Heft 10, Mai 1968, Seite 306 München,
DE. J. MACHTS: "Einschubtastensatz für die Diodenabstimmung von Fernsehgeräten"**

(73) Patentinhaber : **PREH, Elektrofeinmechanische
Werke Jakob Preh Nachf. GmbH & Co.
Postfach 1740 Schweinfurter Strasse 5
D-8740 Bad Neustadt/Saale (DE)**

(72) Erfinder : **Bauer, Karl-Heinz
Lerchenstrasse 9
D-8740 Bad Neustadt/Saale (DE)**

**Beschreibung**

Die Erfindung geht von einem Drucktastenaggregat nach dem Oberbegriff des Anspruches 1 aus.

Derartige Drucktastenaggregate werden in verschiedenen Ausführungsformen bevorzugt bei der Abstimmung und Einschaltung von HF-Empfängern, wie z. B. Rundfunk- oder Fernsehempfängern, eingesetzt. Durch einen einzigen Tastendruck kann jeweils die voreingestellte Abstimmspannung und damit die zugeordnete Station bzw. der Kanal eingeschaltet werden. Die Speicherung der eingestellten Abstimmspannung erfolgt in Kanalspeichern in der Form von als Spannungsteiler geschalteten Spindelwiderständen. Die Kanalspeicher und deren Anzeigemittel sowie eventuell zur Frequenzbereichsvorwahl vorgesehene Einstellorgane brauchen und sollen im Normalbetrieb des Gerätes nicht unmittelbar zugänglich sein, da sie leicht zu einer unwissentlichen oder unbeabsichtigten Fehlbedienung des Gerätes führen können. Außerdem kann bei zunehmender Zahl der Druckdrehknöpfe das Aussehen des Gerätes ungünstig beeinflußt werden.

Zur Vermeidung dieses Nachteiles ist es bereits bekannt (DE-Zeitschrift Funkschau 1968, Heft 10, S. 306) das Drucktastenaggregat in Form eines Einschubes auszubilden, auf dessen auch in eingeschobenem Zustand zugänglichen Stirnseite die Drucktasten für die Schalter angebracht sind, während die Abstimmhandhaben für die Spannungsteiler und für die Bereichswahlorgane erst nach Herausziehen des Aggregates aus dem Gerät bedient werden können. Eine derartige Anordnung ist jedoch wegen der im Gerät erforderlichen Führungen für den Einschub und wegen seiner beweglichen Zuleitungen recht aufwendig und mit Unsicherheitfaktoren behaftet.

Es ist ferner bereits aus der DE-B-1 591 713 ein Drucktastenaggregat bekannt, bei dem jeder Kanalspeicher in einer Tasche bzw. in einer etwas vertieften Aussparung untergebracht ist und wobei jeder Kanalspeicher mit einem in Form einer großen Drucktaste ausgebildeten Deckel versehen ist. Dieser Deckel ist federnd rückstellend dreh- und aufklappbar und er liegt so auf dem Einschaltorgan auf, daß dieses durch Druck auf den geschlossenen Deckel betätigt werden kann. Da das Einschaltorgan neben seiner Schaltfunktion auch noch zur Abstimmung dient, müssen die Einschaltorgane einen relativ großen gegenseitigen seitlichen Abstand besitzen, damit die im gedrückten Zustand tief liegenden Einschaltorgane, die ja gleichzeitig auch zur Abstimmung dienen, noch bequem mit dem Finger gedreht werden können.

Eine geringere Einbaubreite benötigt bei gleicher Anzahl der Druckdrehknöpfe ein weiteres bekanntes Drucktastenaggregat (DE-B-1 911 898), bei dem die Druckdrehknöpfe zur Kanaleinschaltung mittels einzelner Tasten betätigbar sind, die in einer allen Druckdrehknöpfen gemeinsamen Klapptür schwenkbar gelagert sind. Die Frequenzbereichswahl kann nur bei geöffneter Klapptür vorgenommen werden. Im Rahmen der aus Kunststoff hergestellten Klapptür ist an einer der Längsseiten eine Metallschiene befestigt, deren endseitige Lagerzapfen mit je einer Metallhalterung zusammenwirken, die ihrerseits im Gehäuse des Drucktastenaggregates befestigt sind. Dieser konstruktive Mehraufwand soll verhindern, daß die Klapptür an ihren Scharnieren ausbricht.

Eine verschiebbare Abdeckung in Form einer Platte besitzt eine in der GB-A-1 389 520 beschriebene Einrichtung. Diese Einrichtung besteht aus einer in einer Gehäusewand ausgesparten Vertiefung, innerhalb der Steckdosen und Betätigungsknöpfe angeordnet sind. Durch eine verbreiterte Öffnung in der Vertiefung kann die Platte in eine Nut-Steg-Führung eingeschoben werden. Die Platte ist in dieser Führung zwischen einem rechten und einem linken Anschlag verschiebbar. Unabhängig von der Stellung der Platte ist ein Teil der Vertiefung immer unbedeckt. Dies ist aus Designgründen insbesondere dann nachteilig, wenn sich die Einrichtung auf der Frontseite von Geräten befindet. Zur Vermeidung von Schiebegeräuschen besitzt die Platte längsrandseitig Schlitze und vorstehende Federzungen zur straffen Führung des Randes der Platte in einer Nut der Gehäusewand.

Aufgabe der vorliegenden Erfindung ist es, ein Drucktastenaggregat nach der eingangs genannten Art zu schaffen, bei dem die Druckdrehknöpfe gegen eine unwissentliche oder unbeabsichtigte Betätigung durch eine einfach herzustellende Einrichtung geschützt sind und gleichzeitig bei geringeren Kosten das Aussehen des Drucktastenaggregates günstig beeinflußt wird.

Diese Aufgabe wird erfindungsgemäß durch die im kennzeichnenden Teil des Anspruches 1 angegebenen Merkmale gelöst.

Weitere vorteilhafte Ausgestaltungen der Erfindung sind den Unteransprüchen zu entnehmen.

Durch die Ausbildung der Abdeckung als verschiebbares, jalousieähnliches, flexibles Band entfallen für eine Klapptür benötigte Scharniere, die leicht abbrechen können. Ferner ist keine Einschnappvorrichtung erforderlich, die die Klapptür am selbständigen Aufschwenken hindern soll. Da Klapptüren dieser Art nicht voll auf 180 Grad aufschwenkbar sind, ist die Bedienbarkeit bei geöffneter Klapptür beeinträchtigt. Durch die Verwendung eines im Gehäuse verschiebbaren Bandes sind keine vorstehenden Teile vorhanden, die die Bedienbarkeit in irgend einer Weise beeinträchtigen könnten. Ferner ist es möglich, die Vertiefung lang und schmal auszuführen, um einen besseren Schutz in elektrischer und mechanischer Hinsicht zu erlangen. Dies kommt dem Bestreben entgegen, Drucktastenaggregate möglichst mit geringem Platzbedarf auf der Frontseite der Geräte durch einen räumlich gedrängten Aufbau ohne Verlust der leichten Bedienbarkeit zu konstruieren. Außerdem erweist sich das verschiebbare Band gegenüber einer Klapptür als günstiger hinsichtlich eines Staub- und Feuchteschutzes durch die Nut-Steg-Führung. Ein weiterer Vorteil des verschiebbaren Bandes liegt darin, daß bei teilweise verschobenem Band Zusatzeinrichtungen im Anfangschiebebereich, wie z. B. eine Kopfhörerbuchse, leicht zugänglich sind, ohne daß Teile vorstehen und leicht beschädigt werden können. Bei Anwendung einer Klapptür müßte man diese im geschlossenen Zustand mit einem eigenen verdeckbaren Durchbruch versehen oder die ganze Klapptür öffnen.

Einzelheiten der Erfindung werden nachfolgend für mehrere Beispiele anhand der Zeichnungen näher beschrieben.

Von den Figuren zeigt

Figur 1 eine Vorderansicht eines Drucktastenaggregates,

Figur 2 eine Seitenansicht des Drucktastenaggregates teilweise im Schnitt,

Figur 3 eine Abdeckung in der Form eines flexiblen Bandes in perspektivischer Ansicht,

Figur 4 ein weiteres Ausführungsbeispiel eines flexiblen Bandes in perspektivischer Ansicht und

Figur 5 ein weiteres Ausführungsbeispiel eines flexiblen Bandes in perspektivischer Ansicht.

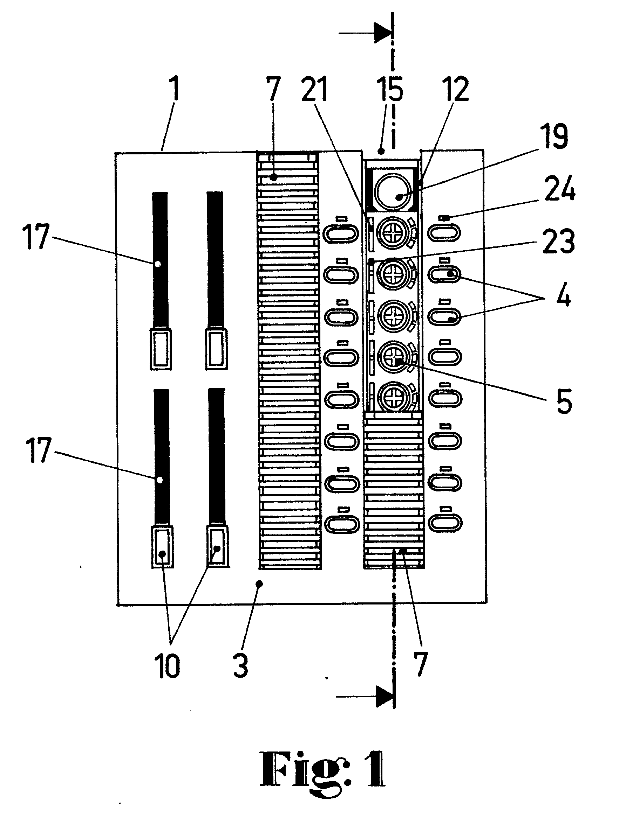

Das in Figur 1 dargestellte und mit 1 bezeichnete Drucktastenaggregat besitzt zwei Reihen zu je acht mittels einer Sperrschiene gegenseitig auslösbaren Drucktasten 4 zur Einschaltung der in den einzelnen Kanalspeichern voreingestellten Abstimmspannungen. Es ist selbstverständlich auch eine hiervon abweichende Anzahl von Drucktasten denkbar. Das Drucktastenaggregat selbst besteht aus einem Gehäuse mit einem Speichergehäuse 18 und einer Gehäusefrontseite 3, in dem Einstell-, Schalt- und Anzeigeorgane zu einer Baueinheit zusammengefaßt sind.

Bei dem in Figur 1 dargestellten Ausführungsbeispiel bestehen die einzelnen Einstellorgane für die Lautstärke, Bildhelligkeit, Kontrast usw. aus mehreren Schiebewiderständen 17, die seitlich zu den Drucktastenreihen angeordnet sind. Anstelle der Schiebewiderstände können auch Drehwiderstände Verwendung finden. Es ist hierbei selbstverständlich, daß die Anordnung der Einstellorgane, seien es nun Schiebe- oder Drehwiderstände, auch ober- und unterhalb der Drucktastenreihe möglich ist.

Die hier verwendeten Schiebewiderstände bestehen in bekannter Weise aus einem Widerstandselement und einer Kollektorbahn. Beide werden elektrisch überbrückt durch eine Schleifkontaktfeder aus Metall, die an einem Federträger befestigt ist. Dieser Federträger kann in einem Widerstandsgehäuse geführt sein, das seinerseits an der Gehäusefrontseite befestigt ist. Dies hat den Vorteil, daß das Widerstandsgehäuse auch getrennt als eine Baueinheit Verwendung finden kann. Von dem Federträger ragt ein Ansatz durch den Schlitz der Gehäusefrontseite 3, wobei das freie Ende des Ansatzes als Federzungen ausgebildet ist, auf die ein Bedienungsknopf 10 aufgeschnappt ist.

Als Schaltorgane kann — falls erforderlich — zusätzlich ein Netzschalter in der Gehäusefrontseite befestigt werden. Auch dieser Netzschalter besitzt zweckmäßigerweise ein eigenes Netzschaltergehäuse, so daß er für sich allein als eigene Baueinheit eingesetzt werden kann.

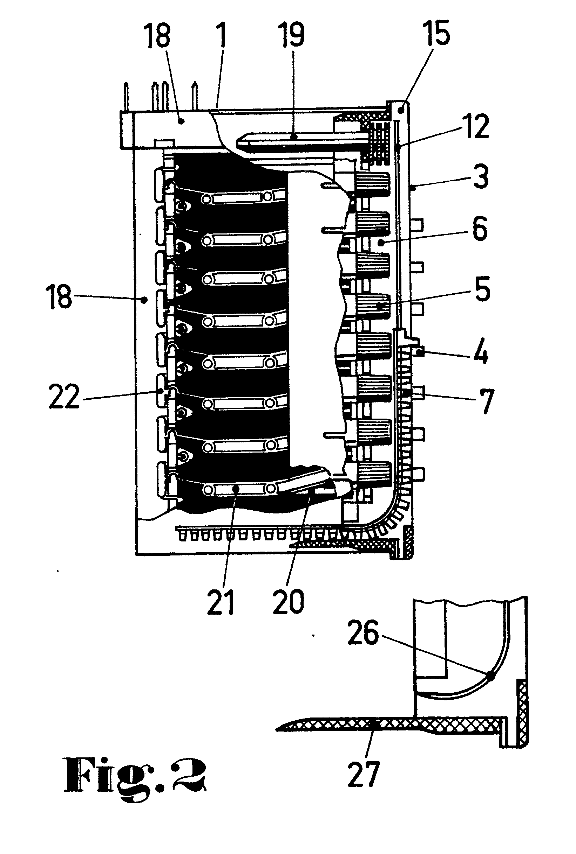

Hinter den Drucktasten 4 ist das eigentliche Speichergehäuse 18 angeordnet, wie aus Figur 2 zu entnehmen ist. In diesem befinden sich Spindelwiderstände, die die Kanalspeicher darstellen. Diese bestehen aus einer Spindel, auf der ein Federträger entlanggeführt ist, auf dem eine Schleiffeder befestigt ist, die zwischen Widerstand und Spindel eine elektrische Verbindung herstellt. Durch die Stellung des Federträgers wird die Abstimmspannung eingestellt. Die einzelnen Widerstände sind nebeneinander auf einer Isolierstoffplatte aufgebracht, die im Speichergehäuse gehaltert ist. An einem Ende weist die Spindel einen Druckdrehknopf 5 auf, der in die Vertiefung 6 der Gehäusefrontseite 3 ragt und der mit einer geriffelten oder sonstwie griffig gestalteten Randung — falls Handbedienung ohne Hilfsmittel erfolgt — versehen ist. Der Druckdrehknopf 5 ist außerdem mit einer Höhlung versehen, die ein bestimmtes Innenprofil besitzt. Zur Abstimmung wird ein Steckschlüssel 19 in diese Höhlung gesteckt, wobei auch der Steckschlüssel ein Außenprofil aufweist, das mit dem Innenprofil im Sinne einer Mitnahme zusammenwirkt. Mit dem Steckschlüssel können auch die Schaltorgane für die Frequenzbereichswahl betätigt werden. Hierzu muß der Druckdrehknopf lediglich gedrückt und anschließend in eine der Schaltpositionen gedreht werden.

Der jeweilige Federträger der Spindelwiderstände besitzt einen angeformten Zapfen, der durch eine längliche Ausnehmung 20 im Speichergehäuse 18 in ein in Figur 2 nicht sichtbares Langloch eines Anzeigeorganes hineinragt. Dieses Langloch erstreckt sich über den ganzen Abstimmbereich. Das Anzeigeorgan selbst besteht aus auslenkbaren Anzeigezungen 21, die im Bereich der Einstellstrecke dieses Langloch besitzen und die an einem Ende an einer Befestigungsschiene 22 einstückig angeformt und angelenkt sind. Diese Befestigungsschiene ist für alle Anzeigezungen gemeinsam und sie ist mit Hilfe von Schnappverbindungen im Speichergehäuse 18 gehaltert. Das andere Ende ist abgewinkelt, wobei diese Abwinkelung in einer Aussparung 23 in der Vertiefung 6 der Gehäusefrontseite sichtbar ist. Das Langloch selbst ist leicht gekrümmt, so daß die Anzeigezungen je nach Stellung des Federträgers ausgelenkt werden. Hierdurch ist es möglich, die jeweilige Stellung des Federträgers und damit die eingestellte Abstimmspannung leicht anzeigen zu können.

Um die Stellung der Drucktasten auch aus der Ferne besser erkennen zu können, kann das Drucktastenaggregat mit einer zusätzlichen Leuchtanzeigeeinrichtung versehen werden. Diese kann z. B. aus mehreren Lichtleitern bestehen, die sternförmig von einem Leuchtzentrum aus zu den einzelnen Drucktasten hin geführt sind und deren Ende in einem Fenster 24 der Gehäusefrontseite sichtbar sind. Das Leuchtzentrum selbst besteht aus einer Fassung aus durchsichtigem Kunststoff, in derem Hohlraum eine Lampe eingesetzt ist. Die Enden der Lichtleiter, die zu den Drucktasten führen, besitzen Lichtstrahlenunterbrechungsmittel, wobei bei nicht gedrückter Drucktaste die Lichtstrahlen unterbrochen sind, so daß die in den Fenstern sichtbaren Enden dunkel sind.

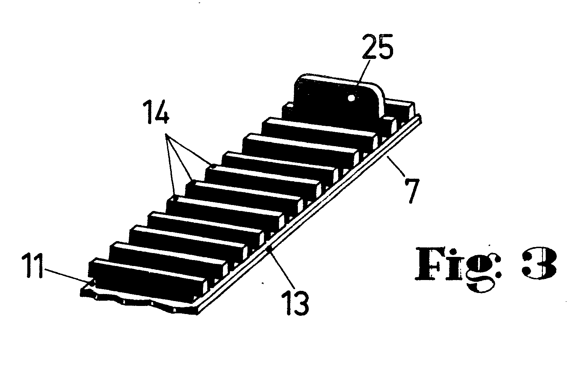

Da die Einstell- und Anzeigeorgane im Normalbetrieb des Gehäuses nicht unmittelbar zugänglich sein sollen, befinden sich diese in der Vertiefung 6 der Gehäusefrontseite 3. Diese Vertiefung ist durch eine Abdeckung verdeckt, die in der Gehäusefrontseite längs verschiebbar ist. Hierdurch soll eine unwissentliche oder unbeabsichtigte Fehlbedienung des Gerätes vermieden werden. In den Figuren 3 bis 7 sind mehrere Ausführungsbeispiele einer Abdeckung dargestellt. Die Abdeckung kann auch aus einem starren Schieber bestehen. Die Abdeckung gemäß den Figuren besteht aus einem flexiblen Band, das in der Gehäusefrontseite beim Verschieben umgelenkt wird. Um die Abdeckung überhaupt verschieben zu können, ist sie mit einer Betätigungshandhabe 25 versehen. Ferner besitzt die Gehäusefrontseite eine Einführungsöffnung 15 für das Band. Die Führung für das Band in der Gehäusefrontseite ist im übrigen eine Nut-Steg-Führung. Hierzu ist am Rand der Vertiefung beidseitig ein Steg 12 angeformt.

Bei dem ersten Ausführungsbeispiel nach Figur 3 besteht das flexible Band 7 aus einem länglichen Basisteil 13, an dem senkrecht zur Verschieberichtung liegende Rippen 14 angeformt sind. Die Höhe der Rippen ist so bemessen, daß deren Oberfläche mit der der Gehäusefrontseite fluchtet. Damit wird optisch ein günstiges Aussehen erreicht. Seitlich besitzen die Rippen Ausnehmungen 11, in die der Steg 12 der Gehäusefrontseite hineinragt. Auf diese Weise entsteht eine Nut-Steg-Führung für das Band.

Wie aus der Darstellung der Einzelheit in Figur 2 ersichtlich ist, macht der Steg 12 an der der Eintrittsöffnung entgegengesetzter Seite einen Bogen 26 von der Frontseite weg. Ferner ist an der Unterseite der Gehäusefrontseite ein Wandabschnitt 27 angeformt. Wird das Band nun nach unten verschoben, so wird es am Bogen umgelenkt und zwischen dem Wandabschnitt 27 und dem Speichergehäuse lose geführt. Der Bogen stellt somit das Umlenkmittel für das Band dar. Um das Band besser in die Führung einbringen zu können, ist der Bogen am Anfang leicht abgerundet und spitz zulaufend.

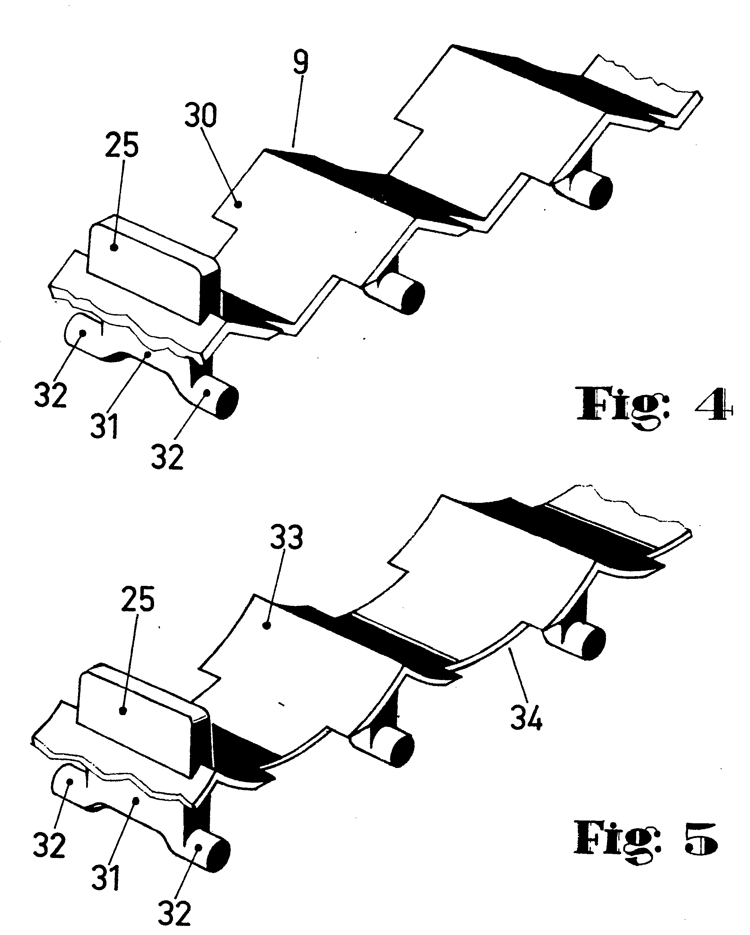

Zwei weitere Ausführungsbeispiele sind in den Figuren 4 und 5 dargestellt. In Figur 4 besteht das Band 9 aus mehreren Gliedern, die miteinander verbunden sind. Jedes Glied setzt sich aus einem satteldachartigen Oberteil 30 und einem Unterteil 31 zusammen. Beidseitig sind an das Unterteil 31 Zapfen 32 angeformt. Das Band ist nun so in der Gehäusefrontseite geführt, daß der Steg zwischen dem Zapfen und dem überstehenden Oberteil zu liegen kommt.

Eine andere Ausführung des Oberteils ist in Figur 5 dargestellt. Hier sind die Oberteile 33 so ausgebildet, daß sie girlandenförmig zusammenhängend sind. Ansonsten entspricht die Funktionsweise des Bandes 34 der des Bandes 9 in Figur 4.

## Ansprüche

1. Drucktastenaggregat (1) für Empfangsgeräte der Nachrichtentechnik, insbesondere für Rundfunk- und Fernsehempfänger, mit einem Gehäuse, mit sich gegenseitig auslösenden Drucktasten (4) zur Einschaltung einspeicherbarer, wahlweise einstellbarer elektrischer Werte von aus mehreren Spannungsteilern für Kapazitätsdiodenabstimmung bestehenden Kanalspeichern, mit den jeweiligen Drucktasten (4) zugeordneten, drehbaren und verschiebbaren Druckdrehknöpfen (5) zur Kanalabstimmung und bedarfsweise zur Auswahl eines Frequenzbereiches, der in einer von der Abstimmstellung verschiedenen -vorzugsweise gedrückten-Stellung des Druckdrehknopfes durch Drehen in verschiedene rastende Winkelstellungen einstellbar ist, wobei die in einer Vertiefung des Gehäuses angeordneten Druckdrehknöpfe (5) durch eine Abdeckung (7, 9, 34) verdeckt sind, die eine angeformte Betätigungshandhabe (25) besitzt, dadurch gekennzeichnet, daß die Abdeckung (7, 9, 34) aus einem im Gehäuse längs verschiebbaren, flexiblen Band besteht, das durch eine Nut-Steg-Führung im Gehäuse (3, 18) gleitbeweglich in seiner Längsrichtung gelagert ist, wobei je ein Steg (12) beidseitig am Rand der Vertiefung (6) im Gehäuse (3, 18) läuft und die Nut (11) sich im flexiblen Band befindet, und daß die Vertiefung (6) auf einer Seite am oberen Rand eine Einführungsöffnung (15) für das flexible Band besitzt und auf der anderen Seite Umlenkmittel (26) im Gehäuse vorhanden sind.

2. Drucktastenaggregat nach Anspruch 1, dadurch gekennzeichnet, daß das Band aus einem durchgehenden Basisteil (13) und aus an diesem Basisteil angeformten, im Abstand parallel nebeneinander und senkrecht zur Verschieberichtung liegenden Rippen (14) besteht.

3. Drucktastenaggregat nach Anspruch 1 und 2, dadurch gekennzeichnet, daß der Steg (12) in Ausnehmungen (11) der Rippen (14) eingreift, um ein Führen des Bandes im Gehäuse zu bewirken.

4. Drucktastenaggregat nach Anspruch 2, dadurch gekennzeichnet, daß die Oberfläche der Abdeckung (7, 9, 34) mit der Oberfläche des Gehäuses zumindest teilweise fluchtet.

5. Drucktastenaggregat nach Anspruch 1, dadurch gekennzeichnet, daß das Band (9) aus mehreren, miteinander verbundenen Gliedern besteht, wobei jedes Glied ein satteldachartiges Oberteil (30) und ein beidseitig mit je einem Zapfen (32) versehenes Unterteil (31) besitzt und wobei der Steg (12) des Gehäuses sich zwischen Oberteil (30) und dem Zapfen (32) des Unterteils (31) befindet, so daß das Band im Gehäuse geführt wird.

## Claims

1. Push-button unit (1) for receivers in the communications art, particularly for radio and television receivers, having a housing, having mutually releasing push-buttons (4) for connecting storable, optionally variable electrical values of channel stores comprising several voltage dividers for capacitance diode tuning, having rotatable and displaceable rotary push-buttons (5) associated with the respective push-buttons (4) for channel tuning and if necessary for selecting a frequency range which is selectable in a — preferably depressed — position of the rotary push-button, which is different from the tuning position, by turning into various locking angular positions, the rotary push-buttons (5) arranged in a depression in the housing being covered by a cover (7, 9, 34), which has a moulded-on operating handle (25), characterised in that the cover (7, 9, 34) consists of a flexible band which is longitudinally displaceable in the housing and mounted to be slidable in its longitudinal direction in the housing (3, 18) by means of a tongue-and-groove guide, a respective tongue (12) extending on both sides on the edge of the depression (6) in the housing (3, 18), and the groove (11) being located in the flexible band, and in that the depression (6) has an insertion aperture (15) for the flexible band at the upper edge on one side, and deflection means (26) are provided in the housing on the other side.

2. Push-button unit according to claim 1, characterised in that the band consists of a continuous base part (13) and of ribs (14) moulded to this base part and lying in parallel spaced arrangement relative to each other and perpendicular to the direction of displacement.

3. Push-button unit according to claims 1 and 2, characterised in that the tongue (12) engages into recesses (11) of the ribs (14), in order to effect guiding of the band in the housing.

4. Push-button unit according to claim 2, characterised in that the surface of the cover (7, 9, 34) is at least partly flush with the surface of the housing.

5. Push-button unit according to claim 1, characterised in that the band (9) consists of several members connected to each other, each member having a ridge-roof-type upper part (30) and a lower part (31) provided on both sides with one respective pin (32), and the tongue (12) of the housing being located between the upper part (30) and the pin (32) of the lower part (31), so that the band is guided in the housing.

## Revendications

1. Bloc (1) à boutons-poussoirs pour appareils récepteurs de télécommunication, notamment pour radio-récepteurs et téléviseurs, comportant un boîtier à boutons-poussoirs (4) qui se déclenchent mutuellement de façon à mettre en circuit des valeurs électriques mémorisables et réglables à volonté, provenant de plusieurs mémoires de canaux composées de diviseurs de tension destinés à réaliser l'accord à l'aide de diodes capacitives, ainsi que des boutons-poussoirs rotatifs (5) coopérant avec les boutons-poussoirs (4) respectifs pour accorder les canaux et, si besoin est, choisir une gamme de fréquences, qui peut être obtenue dans une position du bouton rotatif (5) différente de la position de réglage (avantageusement la position d'enfoncement) par rotation à diverses positions angulaires à crans d'arrêt, ces boutons rotatifs (5), disposés dans une cavité du boîtier, étant recouverts par un couvercle (7, 9, 34) sur lequel un élément de manœuvre (25) est formé, bloc caractérisé en ce que le couvercle (7, 9, 34) est une bande flexible qui peut coulisser longitudinalement dans le boîtier, qui est montée dans ce boîtier (3, 18) de manière à pouvoir coulisser dans le sens de sa longueur dans une glissière à rainure et languette, une languette (12) suivant sur chacun des deux côtés le bord de la cavité (6) dudit boîtier (3, 18) et la rainure (11) étant formée dans cette bande flexible, et la cavité (6) comporte d'un côté, sur son bord supérieur, une ouverture (15) d'introduction de la bande flexible et le boîtier comporte de l'autre côté des éléments déviateurs (26).

2. Bloc à boutons-poussoirs selon la revendication 1, caractérisé en ce que la bande est constituée d'une partie de base (13) continue et de nervures (14) formées sur cette partie de base et disposées parallèlement côte à côte, perpendiculairement au sens de coulissement.

3. Bloc à boutons-poussoirs selon les revendications 1 et 2, caractérisé en ce que la languette (12) est engagée dans des encoches (11) des nervures (14) de manière à guider la bande dans le boîtier.

4. Bloc à boutons-poussoirs selon la revendication 2, caractérisé en ce que la surface du couvercle (7, 9, 34) est au moins en partie dans le plan de la surface du boîtier.

5. Bloc à boutons-poussoirs selon la revendication 1, caractérisé en ce que la bande (9) est composée d'un certain nombre d'éléments reliés entre eux, chaque élément comportant une partie supérieure (30) en dos d'âne et une partie inférieure (31) présentant de chaque côté un tourillon (32), la languette (12) du boîtier passant entre cette partie supérieure (30) et le tourillon (32) de cette partie inférieure (31), de façon à guider la bande dans le boîtier.

**Fig. 1**

**Fig.2**

Fig: 3

Fig: 4

Fig: 5